# EUROPEAN PATENT APPLICATION

(11) **EP 1 550 518 A2**
(43) Date of publication of application: **06.07.2005**
(21) Application number: 04258026.6
(22) Date of filing: 22.12.2004
(51) Int. Cl.: B08B 3/12, B08B 7/00, H01L 21/00

(54) **Megasonic cleaning vessel**

(30) Priority: 02.01.2004 US 751085
(71) Applicant: THE BOC GROUP, INC., Murray Hill, New Providence, New Jersey 07974 (US)
(72) Inventor: Dickinson, Colin John, San Jose, California 95123 (US)
(74) Representative: Booth, Andrew Steven

(57) **Abstract**

A megasonic cleaning vessel (10) for cleaning a semiconductor wafer includes a top chamber wall (11), a bottom chamber wall (12), and side walls (14) extending between the top chamber wall (11) and the bottom chamber wall (12) forming a cleaning chamber (16). A megasonic transducer (40) is provided in the cleaning chamber (16). A pedestal (20) extends upwardly from the bottom chamber wall (12) for supporting a semiconductor wafer, and an electrical conduit (24) is provided through the cleaning vessel (16) for connecting an electrical cable (25) to the megasonic transducer (40) at atmospheric pressure.

## Description

This present invention relates to a cleaning vessel employing megasonic energy to clean materials, especially, semiconductor wafers.

When processing semiconductor wafers, it is necessary to remove contaminants from the surfaces of these semiconductor wafers. These contaminants consist of organic and inorganic materials in the form of particulate, and have been removed using ultrasonic energy (20-200 Kilohertz). For example, the semiconductor wafers are submerged in a liquid. The liquid is used as a working medium, and the ultrasonic energy is applied thereto. The ultrasonic energy causes the liquid to cavitate, and to thereby form vacuum bubbles that subsequently collapse. The formation and collapse of these bubbles in the working medium releases energy, and the working medium is agitated by this energy. The agitation in the working medium is enough to dislodge large particulate from the semiconductor wafers.

To dislodge very small particulate, however, agitation caused by the energy released through the formation and collapse of vacuum bubbles is inadequate. Therefore, megasonic energy (200-2000 Kilohertz) has been used instead of ultrasonic energy. For example, megasonic energy does not allow the liquid used as the working medium to cavitate. Therefore, the megasonic energy can be transmitted through the working medium, and be applied directly to the semiconductor wafers. The direct application of the megasonic energy has been effective in removing small particulate.

The present invention provides a megasonic cleaning vessel for cleaning a semiconductor wafer, the vessel comprising: a top chamber wall; a bottom chamber wall; side walls extending between said top chamber wall and said bottom chamber wall to provide a cleaning chamber; a megasonic transducer provided in said cleaning chamber; a pedestal extending upwardly from said bottom chamber wall for supporting the semiconductor wafer; and an electrical conduit provided through the cleaning vessel for connecting an electrical cable to said megasonic transducer at atmospheric pressure.

The megasonic cleaning vessel preferably comprises a transducer housing provided in the cleaning chamber, and adapted to hold said megasonic transducer. In certain embodiments, the electrical conduit comprises a first electrical cable port provided through the top chamber wall, and a second electrical cable port provided through the transducer housing.

The transducer housing may be formed from a top housing wall, a bottom housing wall, and an interior wall and exterior wall extending therebetween, with the second electrical cable port provided through said top housing wall. In certain embodiments, the first electrical cable port and the second electrical cable port are joined to form the electrical conduit using a sealing sleeve.

The cleaning vessel preferably contains a working medium. When liquid is used as the working medium, it is difficult to fill the cleaning vessel. Generally, liquids have high viscosities, and, therefore, significant periods of time are required to fill the cleaning vessel. Moreover, when the cleaning process is complete, significant periods of time are required to empty the cleaning vessel of the liquid. In view of this, the working medium is preferably transformed from a gas into a supercritical fluid inside the cleaning vessel. For example, the cleaning vessel can be filled and evacuated over a shorter period of time using a gas instead of a liquid, and the cleaning vessel can be raised above the critical pressure and critical temperature to transform the gas into the supercritical fluid.

The cleaning chamber is preferably adapted to receive a working medium such as carbon dioxide, and the megasonic transducer is preferably adapted to conduct megasonic energy to the carbon dioxide in the supercritical state. The electrical conduit is preferably isolated from the supercritical carbon dioxide contained in the cleaning chamber.

Preferred features of the present invention will now be described, by way of example only, with reference to the accompanying drawings, in which:-
Figure 1 is a perspective view of the exterior of the cleaning vessel;
Figure 2 is a cross-sectional view of the cleaning vessel along Line 2-2 of Figure 1; and

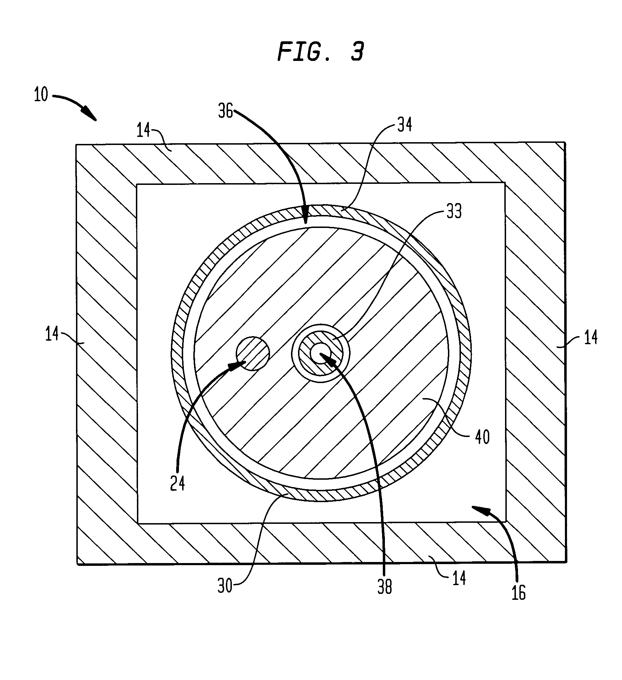

Figure 3 is a cross-sectional view of the cleaning vessel along Line 3-3 of Figure 2.

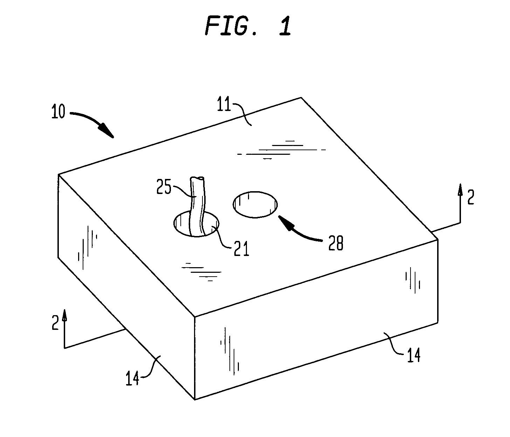

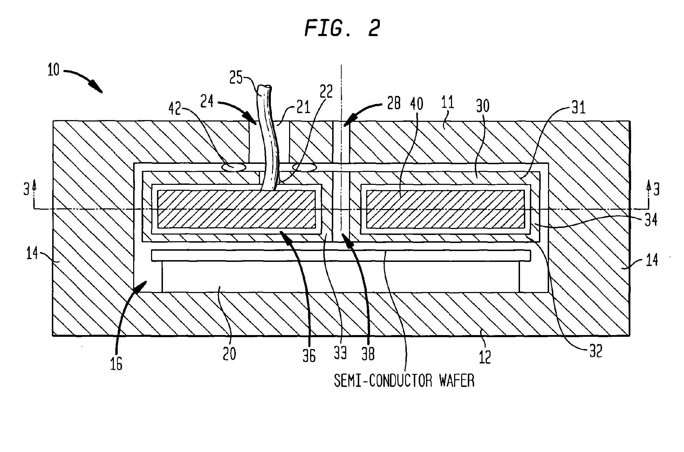

Referring to Figures 1 and 2, the cleaning vessel for cleaning surfaces of a semiconductor wafer is generally indicated by the numeral 10. The cleaning chamber is formed from a top chamber wall 11, a bottom chamber wall 12 and chamber side walls 14. Together, the top chamber wall 11, bottom chamber wall 12, and chamber side walls 14 define a cleaning chamber 16.

A pedestal 20 adapted to carry the semiconductor wafers extends upwardly from the bottom chamber wall 12 in the cleaning chamber 16. The chamber side walls 14 can be segmented, and together with the top chamber wall 11 form a lid, and together with the bottom chamber wall 12 form a base. The lid could be vertically adjusted relative to the base (from a closed position to an open position) to provide access to the cleaning chamber. Thereafter, the semiconductor wafer can be positioned on the pedestal 20, the lid could be vertically adjusted relative to the base (from the open position to the closed position), and the cleaning process can be initiated. After the cleaning process is complete, the lid could be vertically adjusted relative to the base (from the closed position to the open position) to again provide access to the cleaning chamber 16.

A first electrical cable port 21 extends through the top chamber wall 11 and provides for communication between the exterior of the cleaning vessel 10 and the cleaning chamber 16. As discussed hereinbelow, the first electrical cable port 21 is joined to a second electrical cable port 22 to form an electrical conduit 24. The electrical conduit 24 allows passage of an electrical cable 25 into the cleaning vessel 10. A fluid inlet 28 also extends through the top chamber wall 11. The fluid inlet 28 is attached to piping (not shown), and is used to transport a working medium into the cleaning chamber 16.

A transducer housing 30 is positioned in the cleaning chamber 16. The transducer housing 30 is ring-shaped, and includes a top housing wall 31 and a bottom housing wall 32. Extending between the top housing wall 31 and the bottom housing wall 32 are an interior cylindrical wall 33 and an exterior cylindrical wall 34. A cavity 36 is defined by the top housing wall 31, the bottom housing wall 32, and the interior and exterior cylindrical walls 33 and 34, and a cylindrical hole 38 through the transducer housing 30 is formed by the interior cylindrical wall 33.

The working medium may be carbon dioxide (CO₂), which is ultimately transformed into supercritical CO₂ inside the cleaning chamber 16. For example, gaseous CO₂ enters the cleaning chamber 16 at pressures above atmosphere. The gaseous CO₂ flows through the fluid inlet 28, and is directed around the transducer 30 and through the cylindrical hole 38. Because the viscosity of gaseous CO₂ is significantly less than the viscosity of liquid CO₂, the gaseous CO₂ is capable of filling the cleaning chamber 16 is a relatively short period of time. After filling the cleaning chamber 16, the gaseous CO₂ is transformed into supercritical CO₂ by raising the pressure and temperature inside the cleaning chamber 16 above the critical pressure (72.9 atmospheres) and critical temperature (31.3° C) of CO₂. During operation, the working fluid is held at pressure and temperatures above its critical pressure and critical temperature, and the supercritical CO₂ is dense enough to conduct megasonic energy, as discussed hereinbelow. Moreover, some organic materials are soluble in supercritical CO₂. Consequently, the supercritical CO₂ is capable of removing such organic materials from the surface of the semiconductor wafer.

A megasonic transducer 40 is provided in the cavity 36. The megasonic transducer 40 is ring-shaped, and produces megasonic energy in the form of high frequency vibrations ranging from 200 to 2,000 Kilohertz. During operation, these high frequency vibrations are directed downwardly through the transducer housing 30 to excite the working medium above the pedestal 20. The high frequency vibrations are transmitted from the transducer housing 30 to the working medium to create a series of pressure waves in the working medium. These pressure waves are conducted by the supercritical CO₂, and are directed downwardly toward the pedestal 20 and the semiconductor wafer carried by the pedestal 20. When applied to the surface of the semiconductor wafer, these pressure waves dislodge remaining particulate materials. Therefore, because the working medium during operation of the cleaning vessel 10 is supercritical CO₂, some organic materials are dissolved by the supercritical CO₂, and the remaining particulate materials are dislodged by the megasonic energy conducted by supercritical CO₂.

After the organic materials are dissolved and the remaining particulate materials are dislodged, the working medium containing these contaminants ultimately can be evacuated through the fluid inlet 28. However, before evacuation, the pressure and temperature inside the cleaning chamber 16 are lowered below the critical pressure and critical temperature. Consequently, the supercritical CO₂ is transformed into gaseous CO₂, and the gaseous CO₂ (containing the above-discussed contaminants) may be emptied from the cleaning chamber 16 using the fluid inlet 28. As discussed above, the viscosity of gaseous CO₂ is significantly less than the viscosity of liquid CO₂, and therefore, the gaseous CO₂ is capable of being emptied from the cleaning chamber 16 in a relatively short period of time.

The megasonic transducer 40 requires an electrical supply to operate. Therefore, the second electrical cable port 22 is provided through the top housing wall 31 to allow passage of the electrical cable 25 into the cavity 36. For example, a cylindrical sealing sleeve 42 is provided between the top chamber wall 11 and the top housing wall 31. The cylindrical sealing sleeve 42 joins together the first electrical cable port 21 and the second electrical cable port 22 to form the electrical conduit 24.

Furthermore, the cylindrical sealing sleeve 42 seals the electrical conduit 24 against the pressure provided in the cleaning chamber 16, thereby providing access to the megasonic transducer 40 at atmospheric pressure through the electrical conduit 24. Consequently, there is no need for expensive high pressure electrical feedthroughs, and the electrical cable 25 can be conveniently connected to the megasonic transducer 40 at atmospheric pressure.

It will be understood that embodiments(s) described herein is/are merely exemplary, and that one skilled in the art may make variations and modifications without departing from the scope of the invention. All such variations and modifications are intended to be included within the scope of the invention as described hereinabove. It should be understood that any embodiments described hereinabove are only in the alternative, but can be combined.

## Claims

1. A megasonic cleaning vessel for cleaning a semiconductor wafer, the cleaning vessel comprising a top chamber wall, a bottom chamber wall, side walls extending between said top chamber wall and said bottom chamber wall to provide a cleaning chamber, a megasonic transducer provided in said cleaning chamber, a pedestal extending upwardly from said bottom chamber wall for supporting a semiconductor wafer, and an electrical conduit provided through the cleaning vessel for connecting an electrical cable to said megasonic transducer at atmospheric pressure.

2. A megasonic cleaning vessel according to Claim 1, further comprising a transducer housing provided in said cleaning chamber, and adapted to hold said megasonic transducer.

3. A megasonic cleaning vessel according to Claim 2, wherein the electrical conduit comprises a first electrical cable port provided through said top chamber wall, and a second electrical cable port provided through said transducer housing.

4. A megasonic cleaning vessel according to Claim 3, wherein said transducer housing is formed from a top housing wall, a bottom housing wall, and an interior wall and exterior wall extending therebetween, said second electrical cable port provided through said top housing wall.

5. A megasonic cleaning vessel according to Claim 4, wherein the interior wall is cylindrical and the exterior wall is cylindrical.

6. The megasonic cleaning vessel according to Claim 4 or Claim 5, wherein said first electrical cable port and said second electrical cable port are joined to form said electrical conduit using a sealing sleeve.

7. A megasonic cleaning vessel according to Claim 6, wherein the sealing sleeve is cylindrical.

8. A megasonic cleaning vessel according to any preceding claim, wherein the cleaning chamber is adapted to receive carbon dioxide.

9. A megasonic cleaning vessel according to Claim 8, wherein the megasonic transducer is adapted to conduct megasonic energy to the carbon dioxide in the supercritical state.

10. A megasonic cleaning vessel according to Claim 9, wherein the electrical conduit is isolated from the supercritical carbon dioxide
